# EUROPEAN PATENT APPLICATION

(11) **EP 3 875 405 A1**
(43) Date of publication of application: **08.09.2021**
(21) Application number: 19879593.2
(22) Date of filing: 30.09.2019
(51) Int. Cl.: B65G 15/06, B65G 43/02, B65G 47/52

(54) **CONVEYOR SYSTEM**

(30) Priority: 02.11.2018 JP 2018207432
(71) Applicant: Murata Machinery, Ltd., Kyoto-shi, Kyoto 601-8326 (JP)
(72) Inventor: FUTAMI Takahiko, Ise-shi, Mie 516-0003 (JP); ARAI Shigeyuki, Inuyama-shi, Aichi 484-8502 (JP)
(74) Representative: Jordan, Volker Otto Wilhelm
(86) International application number: PCT/JP2019/038627
(87) International publication number: WO 2020/090323

(57) **Abstract**

A conveyor system (1) includes a first conveyor line (11) configured to convey an article (F) in a first direction, a second conveyor line (13) arranged in parallel with the first conveyor line (11) and configured to convey the article (F) in a second direction that is a direction opposite to the first direction, a backup line (15) arranged in parallel with the first conveyor line (11) and the second conveyor line (13) and provided so as to be able to change states between a state of conveying the article (F) in the first direction and a state of conveying the article (F) in the second direction, first connecting lines (17) each configured to convey the article (F) between the first conveyor line (11) and the backup line (15), and second connecting lines (19) each configured to convey the article (F) between the second conveyor line (13) and the backup line (15).

## Description

### Technical Field

One aspect of the present invention relates to a conveyor system.

### Background Art

As a conveying device configured to convey an article, a conveyor device is known. For example, Patent Document 1 discloses a conveyor system in which two conveyor lines configured to convey articles in directions opposite to each other along one direction are disposed in parallel in the width direction of belt conveyors. In this conveyor system, a backup line that can substitutively convey an article, for example, at the time of a failure of a conveyor line or at the time of a maintenance thereof (hereinafter, these are collectively called "abnormal time of the conveyor line") may be wanted to be arranged. In this case, for example, a backup line may be arranged to each of the conveyor lines configured to convey articles in the directions opposite to each other.

### Citation List

### Patent Literature

[Patent Document 1] Japanese Unexamined Patent Publication No. S61-7133

### Summary of Invention

### Technical Problem

However, arranging the backup lines corresponding to the respective two conveyor lines requires a large space for installation. In some cases, a factory, for example, in which the conveyor system is arranged has only a limited space and the two backup lines cannot be arranged.

In view of this, an object of one aspect of the present invention is to provide a conveyor system in which a backup line configured to substitutively convey an article when abnormality has occurred in a conveyor line can be built compact.

### Solution to Problem

A conveyor system according to one aspect of the present invention is a conveyor system including conveyor devices configured to convey an article while supporting a bottom portion of the article. The conveyor system includes: a first conveyor line configured to convey the article in a first direction; a second conveyor line arranged in parallel with the first conveyor line and configured to convey the article in a second direction that is a direction opposite to the first direction; a backup line arranged in parallel with the first conveyor line and the second conveyor line and provided so as to be able to change states between a state of conveying the article in the first direction and a state of conveying the article in the second direction; first connecting lines each configured to convey the article between the first conveyor line and the backup line; and second connecting lines each configured to convey the article between the second conveyor line and the backup line.

In the conveyor system thus configured, instead of arranging backup lines corresponding to the respective ones of the first conveyor line and the second conveyor line, only one backup line shared by the first conveyor line and the second conveyor line is arranged. This one backup line is configured so as to be able to convey the article in both directions of the first direction and the second direction. The first connecting lines are configured to carry in and carry out the article between the one backup line and the first conveyor line. The second connecting lines are configured to carry in and carry out the article between the one backup line and the second conveyor line. By this configuration, the same function as in the configuration in which backup lines are provided with the respective ones of the first conveyor line and the second conveyor line can be implemented by the one backup line. Consequently, the backup line configured to substitutively convey the article when abnormality has occurred in the conveyor lines can be built compact.

The conveyor system according to one aspect of the present invention may further include: a control unit configured to control the conveyor devices included in each of the first conveyor line, the second conveyor line, the backup line, the first connecting lines, and the second connecting lines; and an abnormal-state recognition unit configured to recognize that abnormality is present in at least one of the conveyor devices included in each of the first conveyor line and the second conveyor line. the control unit may start up at least some of the conveyor devices included in the backup line from a stationary state, and may perform backup control using the first connecting lines, the second connecting lines, and the backup line and to convey the article so as to detour around the at least one of the conveyor devices having the abnormality, when the abnormal-state recognition unit has recognized that abnormality is present. In this configuration, by using the backup line, the first connecting lines, and the second connecting lines that start up at abnormal time, the article is conveyed so as to detour around the abnormal location. Consequently, even if abnormality has occurred in at least one of the first conveyor line and the second conveyor line, conveyance of the article can be continued without stopping the conveyance.

In the conveyor system according to one aspect of the present invention, as the conveyor device, turning conveyor devices each configured to convey the article while supporting a bottom portion of the article and to rotate the article about the vertical direction as a rotation axis may be disposed at connecting portions between the first conveyor line and the first connecting lines, connecting portions between the backup line and the first connecting lines, connecting portions between the second conveyor line and the second connecting lines, and connecting portions between the backup line and the second connecting lines . By this configuration, when an article the front-back orientation of which is specified is conveyed, the article can be conveyed with the orientation being kept.

In the conveyor system according to one aspect of the present invention, the control unit may inhibit rotation of the turning conveyor devices disposed at connecting portions respectively, when the article is located on one of the conveyor devices disposed between two of the connecting portions adjacent to each other. By this configuration, articles can be prevented from colliding with each other during the backup control.

In the conveyor system according to one aspect of the present invention, the control unit may search for a shortest path for detouring around the at least one of the conveyor devices having abnormality, and start up only conveyor devices corresponding to the shortest path, among the conveyor devices included in the backup line. By this configuration, the number of conveyor device to be started up as the backup line can be minimized. Furthermore, the distance in a conveyance direction of the backup line to be used for detouring around one abnormal location can be reduced, whereby the distance in a conveyance direction of a backup line to be used for detouring around another abnormal location can be left longer. Thus, even if abnormality has occurred in a plurality of locations, the possibility of being able to detour around them at the same time can be increased. Consequently, reduction in operating rate when abnormality has occurred in at least one of the first conveyor line and the second conveyor line can be prevented or reduced.

In the conveyor system according to one aspect of the present invention, the backup line may be arranged between the first conveyor line and the second conveyor line in a width direction orthogonal to the first direction. By this configuration, the first connecting lines and the second connecting lines can be built simply.

In the conveyor system according to one aspect of the present invention, the first connecting lines and the second connecting lines may be provided so as to be able to convey the article in both directions of a carry-in direction in which the article is carried into the backup line and a carry-out direction in which the article is carried out from the backup line. By this configuration, to perform the backup control, more detour routes can be selected. Consequently, for example, abnormal locations can be detoured around along a shorter route.

In the conveyor system according to one aspect of the present invention, the first conveyor line and the second conveyor line may be disposed so as to face an inter-level conveying device configured to convey an article in the vertical direction, and also may be connected to a loading-and-unloading conveyor of the inter-level conveying device. Providing the inter-level conveying device requires more space, which often restricts a space in which the conveyor device is arranged. By this configuration, the backup line can be built compact. Thus, even when the inter-level conveying device is arranged, the backup line can be built.

The conveyor system according to one aspect of the present invention may be disposed between different buildings to connect processing systems disposed in the respective different buildings with each other. When the conveyor system is disposed between different buildings, the installation distance thereof is a relatively long distance, which increases cost. By this configuration, only one backup line needs to be installed, and thus increase of the cost can be suppressed.

### Advantageous Effects of Invention

According to one aspect of the present invention, the backup line configured to substitutively convey an article when abnormality has occurred in a conveyor line can be built compact.

### Brief Description of Drawings

[FIG. 1] FIG. 1 is a schematic plan view illustrating a first building, a second building, and an inter-building structure in which a conveyor system according to one embodiment is disposed.
[FIG. 2] FIG. 2 is a plan view illustrating part of the conveyor system disposed in the first building.
[FIG. 3] FIG. 3(A) is a plan view of a first conveyor unit, and FIG. 3(B) is a sectional view taken along line IIIB-IIIB in FIG. 3(A).
[FIG. 4] FIG. 4(A) is a plan view of a second conveyor unit, and FIG. 4(B) is a sectional view taken along line IVB-IVB in FIG. 4 (A) .
[FIG. 5] FIG. 5(A) is a plan view of a turn conveyor unit, and FIG. 5(B) is a sectional view taken along line VB-VB in FIG. 5 (A) .
[FIG. 6] FIG. 6(A) to FIG. 6(D) are diagrams each illustrating one example of backup control when abnormality has occurred in a first conveyor line or a second conveyor line.
[FIG. 7] FIG. 7(A) to FIG. 7(D) are diagrams each illustrating one example of the backup control when abnormality has occurred in both the first conveyor line and the second conveyor line.
[FIG. 8] FIG. 8 is a plan view illustrating part of the conveyor system disposed in the second building.
[FIG. 9] FIG. 9 is a plan view illustrating part of the conveyor system disposed in the inter-building structure.
[FIG. 10] FIG. 10 is a plan view illustratingpart of aconveyor system according to a modification 1.
[FIG. 11] FIG. 11 is a plan view illustrating part of a conveyor system according to a modification 2.

### Description of Embodiments

One preferred embodiment according to one aspect of the present invention will now be described in detail with reference to the drawings. In description of the drawings, like elements are designated by like reference signs, and duplicate description is omitted.

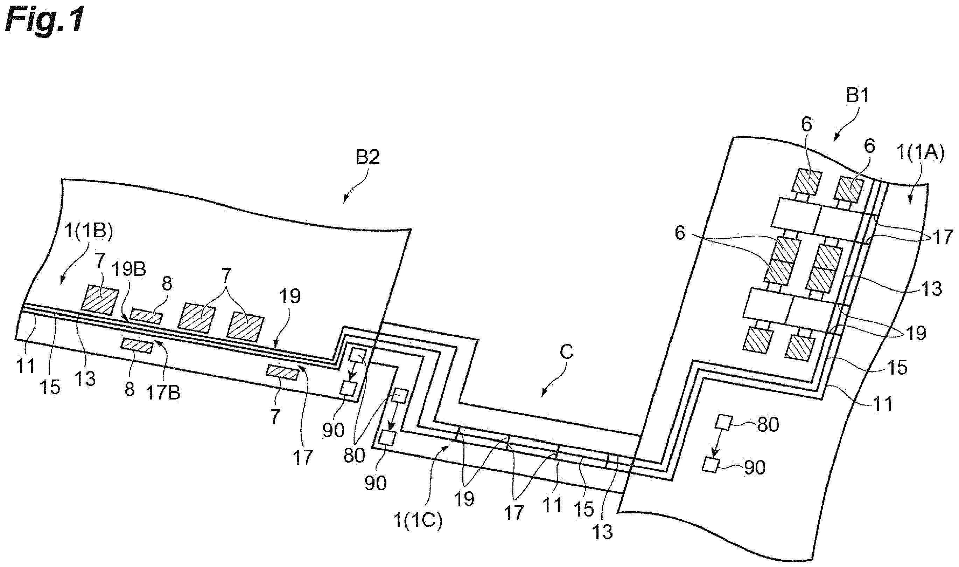

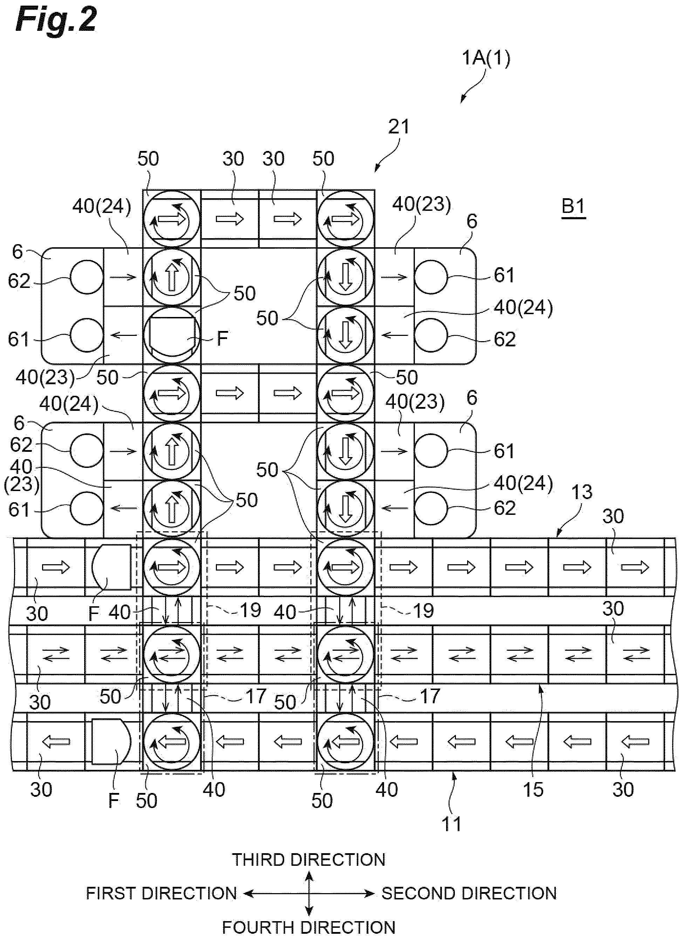

As illustrated in FIG. 1, a conveyor system 1 according to the present embodiment is disposed in each of a first building B1, a second building B2, and an inter-building structure C. In the first building B1, a processing system is provided, which includes: a plurality of stockers 6 each configured to store a container (hereinafter, called "article F". See FIG. 2) in which an object to be conveyed is stored; and a conveyor system 1A configured to carry an article F into the stocker 6 and carry the article F out from the stocker 6. Examples of the article F include a front-opening unified pod (FOUP) configured to accommodate wafers to be processed in a semiconductor manufacturing device or a liquid crystal manufacturing device, for example, and a reticle pod configured to accommodate reticles to be used in the semiconductor manufacturing device or the liquid crystal manufacturing device, for example. In the present embodiment, the FOUP will be described as an example.

In the second building B2, a processing system is provided, which includes: processing devices 7 each configured to perform some type of processing on wafers accommodated in an article F; inter-level conveying devices 8 each configured to move in the vertical direction and convey an article F to another floor level; and a conveyor system 1B configured to carry an article F into the processing device 7 or the inter-level conveying device 8 or carry the article F out from the processing device 7 or the inter-level conveying device 8 is provided. Examples of the processing devices 7 include devices configured to perform, on wafers, various types of processes such as cleaning, ion implantation, thermal treatment, lithography, etching, deposition, and planarization.

The inter-building structure C is disposed between the first building B1 and the second building B2. In the inter-building structure C, a conveyor system 1C is disposed. The conveyor system 1C is disposed between the first building B1 and the second building B2 that are different, and connects the processing systems, each disposed in the first building B1 and the second building B2 that are different, with each other.

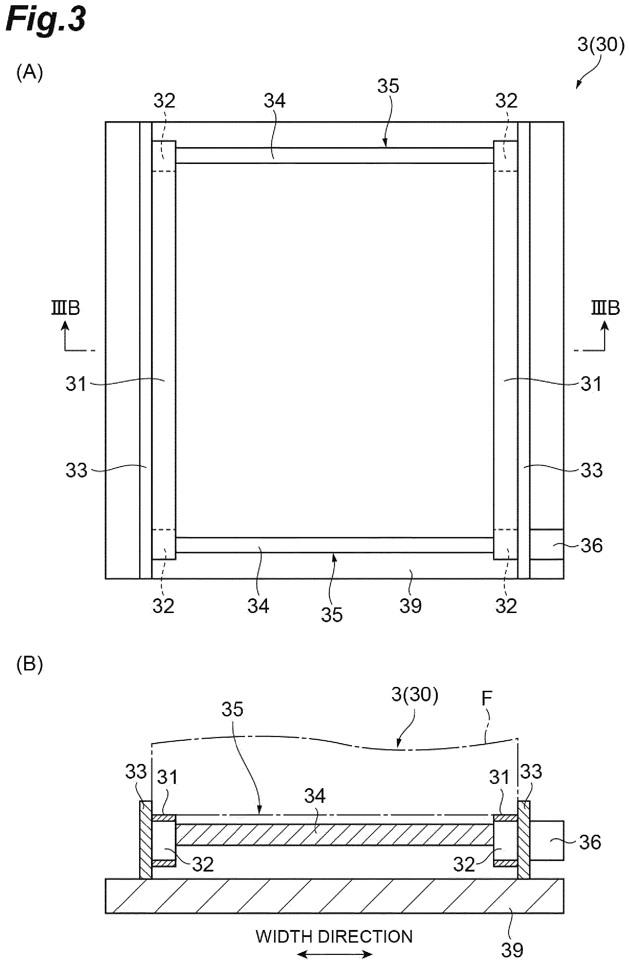

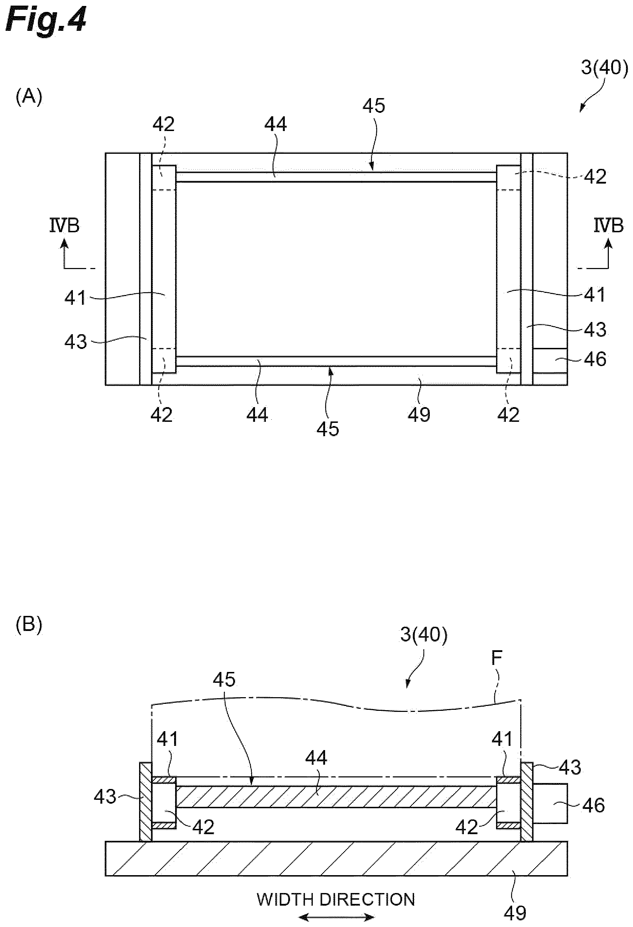

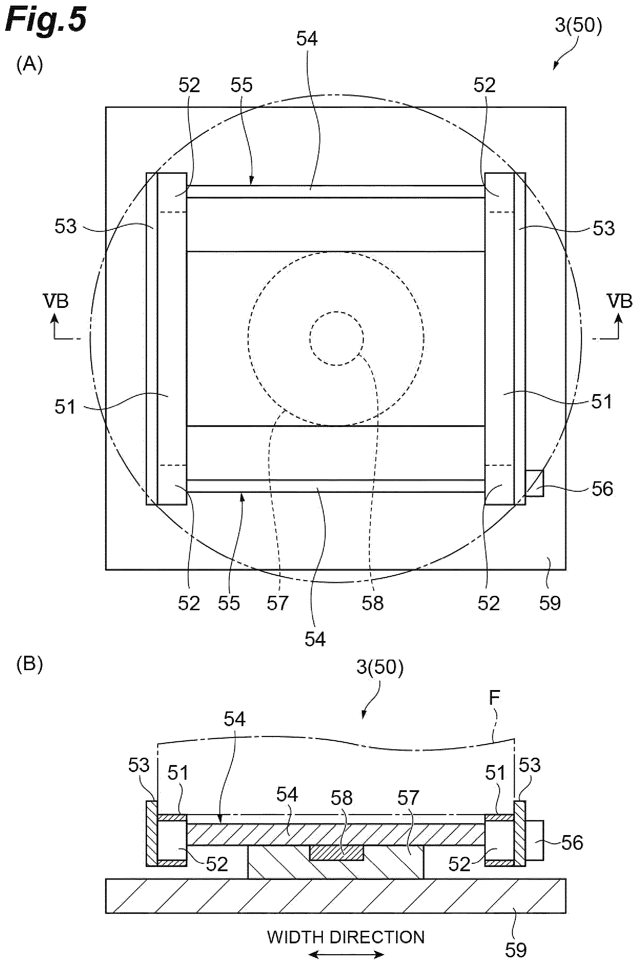

The following describes the conveyor system 1A disposed in the first building B1 in detail. The conveyor system 1A includes, as conveyor units (conveyor devices) 3 each configured to convey an article F while supporting a bottom portion thereof, first conveyor units 30 (see FIG. 3(A) and FIG. 3(B)), second conveyor units 40 (see FIG. 4(A) and FIG. 4(B)), and turn conveyor units (turning conveyor devices) 50 (see FIG. 5(A) and FIG. 5(B)). As illustrated in FIG. 2, the conveyor system 1A includes a first conveyor line 11, a second conveyor line 13, a backup line 15, a plurality of first connecting lines 17, a plurality of second connecting lines 19, an article carry-in-and-out line 21, an abnormal-state recognition unit 80 (see FIG. 1), and a control unit 90 (see FIG. 1) .

The first conveyor line 11 is apart configured to convey an article Fin a first direction. The first conveyor line 11 includes first conveyor units 30 and turn conveyor units 50.

As illustrated in FIG. 3(A) and FIG. 3(B), each first conveyor unit 30 includes a pair of belts 31, 31 configured to support both end portions of a bottom portion of an article F in the width direction thereof to convey the article F. The pair of belts 31, 31 are ring-shaped endless belts, and the belts 31, 31 are respectively wound around a pair of conveyor rollers 35, 35 arranged in the conveyance direction. Each conveyor roller 35 has roller sections 32 around which the belts 31 are wound and a connecting shaft 34 connecting the roller sections 32, 32 to each other. The respective belts 31, 31 are rotated when at least one of the conveyor rollers 35, 35 is driven by a drive section 36, and convey an article F supported thereby in the first direction. The pair of conveyor rollers 35, 35 are supported by guide sections 33. The guide sections 33 have functions of supporting the pair of conveyor rollers 35, 35 and also guiding side surfaces of the article F. The guide sections 33 are supported by a base section 39.

As illustrated in FIG. 5(A) and FIG. 5(B), each turn conveyor unit 50 includes a pair of belts 51, 51 configured to support both end portions of a bottom portion of an article F in the width direction thereof to convey the article F. The pair of belts 51, 51 are ring-shaped endless belts, and the belts 51, 51 are respectively wound around a pair of conveyor rollers 55, 55 arranged in the conveyance direction. Each conveyor roller 55 has roller sections 52 around which the belts 51 are wound and a connecting shaft 54 connecting the roller sections 52, 52 to each other. The respective belts 51, 51 are rotated when at least one of the conveyor rollers 55, 55 is driven by a drive section 56, and convey an article F supported thereby in the first direction.

To the pair of conveyor rollers 55, 55, guide sections 53 are provided. The guide sections 53 have a function of guiding side surfaces of the article F. The pair of conveyor rollers 55, 55 are supported by a turning section 57. The turning section 57 supports the pair of conveyor rollers 55, 55, and also turns the pair of conveyor rollers 55, 55 to change the traveling direction of the article F. The turning section 57 is rotated by a drive section 58 to turn the pair of conveyor rollers 55, 55 supported thereby. The turning section 57 is supported by a base section 59. In other words, the pair of conveyor rollers 55, 55 supported by the turning section 57 are provided in a manner capable of turning with respect to the base section 59.

In the conveyor system 1 according to the present embodiment, as conveyor devices disposed in a connecting portion between the first conveyor line 11 and each first connecting line 17, a connecting portion between the backup line 15 and each first connecting line 17, a connecting portion between the second conveyor line 13 and each second connecting line 19, and a connecting portion between the backup line 15 and each second connecting line 19, the above-described turn conveyor units 50 are provided. In the conveyor system 1 including the turn conveyor units 50 thus configured, an article F like a FOUP the front-back direction of which is specified can be conveyed with the front-back direction being kept.

As illustrated in FIG. 2, the second conveyor line 13 is a part arranged in parallel with the first conveyor line 11 in a width direction orthogonal to the first direction and configured to convey an article F in a second direction opposite to the first direction. In the same manner as the first conveyor line 11, the second conveyor line 13 includes first conveyor units 30 and turn conveyor units 50. The first conveyor units 30 and the turn conveyor units 50 used in the second conveyor line 13 are the same in configuration as the first conveyor units 30 and the turn conveyor units 50 used in the first conveyor line 11 except that an article F is conveyed in the second direction. Thus, detailed description of the first conveyor units 30 and the turn conveyor units 50 is omitted herein.

The backup line 15 is a part configured to function as a backup for the first conveyor line 11 and the second conveyor line 13. The backup line 15 is in a stationary state at a normal time when abnormality is absent in all of first conveyor units 30 and turn conveyor units 50 included in the first conveyor line 11 and the second conveyor line 13, and is used as a detour route at a time (hereinafter, simply called "abnormal time") when abnormality is present in at least one of the first conveyor units 30 and the turn conveyor units 50 included in the first conveyor line 11 and the second conveyor line 13.

The stationary state herein includes both states of a case in which power is not turned on and a case in which power is turned on but the backup line 15 is not operating.

The backup line 15 is arranged in parallel with the first conveyor line 11 and the second conveyor line 13, and also arranged between the first conveyor line 11 and the second conveyor line 13 in the width direction of the first conveyor line 11 and the second conveyor line 13. The backup line 15 is provided so as to be able to change states between a state of conveying an article F in the first direction and a state of conveying the article F in the second direction. In the same manner as the first conveyor line 11, the backup line 15 includes first conveyor units 30 and turn conveyor units 50. The first conveyor units 30 and the turn conveyor units 50 used in the backup line 15 are the same in configuration as the first conveyor units 30 and the turn conveyor units 50 included in the first conveyor line 11 except being provided so as to be able to convey the article F in both directions of the first direction and the second direction. Thus, detailed description of the first conveyor units 30 and the turn conveyor units 50 is omitted herein.

Each first connecting line 17 is a part configured to function as a backup for the first conveyor line 11. The first connecting line 17 conveys an article F between the first conveyor line 11 and the backup line 15. The first connecting line 17 includes a turn conveyor unit 50 included in the first conveyor line 11, a turn conveyor unit 50 included in the backup line 15, and a second conveyor unit 40 interposed between these turn conveyor units 50, 50.

As illustrated in FIG. 4(A) and FIG. 4(B), each second conveyor unit 40 includes a pair of belts 41, 41 configured to support both end portions of a bottom portion of an article F in the width direction thereof to convey the article F. The pair of belts 41, 41 are ring-shaped endless belts, and the belts 41, 41 are respectively wound around a pair of conveyor rollers 45, 45 arranged in the conveyance direction. The distance between the pair of conveyor rollers 45, 45 in the second conveyor unit 40 is shorter than the distance between the pair of conveyor rollers 35, 35 in each first conveyor unit 30.

Each conveyor roller 45 has roller sections 42 around which the belts 41 are wound and a connecting shaft 44 connecting the roller sections 42, 42 to each other. The respective belts 41, 41 are rotated when at least one of the conveyor rollers 45, 45 is driven by a drive section 46, and convey an article F supported thereby in a third direction or a fourth direction orthogonal to the first direction (or the second direction). Specifically, the drive section 46 is provided so as to be able to change rotational directions of the conveyor rollers 45, 45. The pair of conveyor rollers 45, 45 are supported by guide sections 43. The guide sections 43 have functions of supporting the pair of conveyor rollers 45, 45 and also guiding side surfaces of the article F. The guide sections 43 are supported by a base section 49.

The turn conveyor units 50 used in the first connecting line 17 are the same in configuration as the turn conveyor units 50 used in the first conveyor line 11 except being provided so as to be able to convey the article F in both directions of the third direction and the fourth direction orthogonal to the first direction (or the second direction). Thus, detailed description of the turn conveyor units 50 is omitted herein.

Each second connecting line 19 is a part configured to function as a backup for the second conveyor line 13. The second connecting line 19 conveys an article F between the second conveyor line 13 and the backup line 15. The second connecting line 19 includes a turn conveyor unit 50 included in the second conveyor line 13, a turn conveyor unit 50 included in the backup line 15, and a second conveyor unit 40 interposed between these turn conveyor units 50, 50. The second conveyor unit 40 and the turn conveyor units 50 used in the second connecting line 19 are the same in configuration as the second conveyor unit 40 and the turn conveyor units 50 used in the first connecting line 17. Thus, detailed description of the second conveyor unit 40 and the turn conveyor units 50 is omitted herein.

As illustrated in FIG. 2, the article carry-in-and-out line 21 is a part configured to convey an article F between each stocker 6 and the first conveyor line 11 and the second conveyor line 13. The article carry-in-and-out line 21 includes first conveyor units 30, second conveyor units 40, and turn conveyor units 50. The configurations of the first conveyor units 30, the second conveyor units 40, and the turn conveyor units 50 are the same as the configurations of the first conveyor units 30, the second conveyor units 40, and the turn conveyor units 50 described above, and thus description thereof is omitted herein.

Each stocker 6 includes a carry-in port 61 configured to carry an article F therein and a carry-out port 62 configured to carry the article F out therefrom. Between the carry-in port 61 and the corresponding turn conveyor unit 50, a second conveyor unit 40 forming a loading conveyor 23 of the stocker 6 is disposed. An article F is oriented toward the second conveyor unit 40 by turning of the turn conveyor unit 50, and is sent to the second conveyor unit 40. Subsequently, the article F is received by a hand device (not illustrated) provided in the carry-in port 61.

Furthermore, between the carry-out port 62 and the corresponding turn conveyor unit 50, a second conveyor unit 40 forming an unloading conveyor 24 of the stocker 6 is disposed. An article F is passed from the carry-out port 62 to the second conveyor unit 40 by a hand device (not illustrated) provided in the carry-out port 62. Subsequently, the article F is sent to the turn conveyor unit 50, and is conveyed downstream by turning of the turn conveyor unit 50.

The abnormal-state recognition unit 80 (see FIG. 1) is a device configured to recognize that abnormality is present in at least one of the first conveyor units 30 and the turn conveyor units 50 included in the first conveyor line 11 and the second conveyor line 13. The abnormal-state recognition unit 80 detects that abnormality is present in at least one of the first conveyor units 30 and the turn conveyor units 50 described above, or the fact that at least one thereof has abnormality is input to the abnormal-state recognition unit 80. For example, the abnormal-state recognition unit 80 may be a detecting section (not illustrated) such as a sensor configured to detect an article F placed on each conveyor unit 3. Alternatively, when such a detecting section is provided in each conveyor unit 3, the abnormal-state recognition unit 80 may be a device configured to, if a state in which an article F has been detected by one detecting section has continued for a predetermined period of time or longer, recognize the above-described abnormality by detecting that the article F is not moving on or from the conveyor unit corresponding to the one detecting section (detecting that the conveyor unit 3 is stationary). Alternatively, for example, the abnormal-state recognition unit 80 may be a device configured such that a conveyor device having abnormality is input (specified) via, for example, an interface such as a touch panel by an operator or the like who operates the conveyor system 1A.

The control unit 90 controls operation of the conveyor system 1A disposed in the first building B1. The control unit 90 is an electronic control unit including a central processing unit (CPU), a read only memory (ROM), and a random access memory (RAM) . The control unit 90 can be configured as, for example, software such that a program stored in the ROM is loaded into the RAM to be executed by the CPU. The control unit 90 may be configured as hardware such as an electronic circuit.

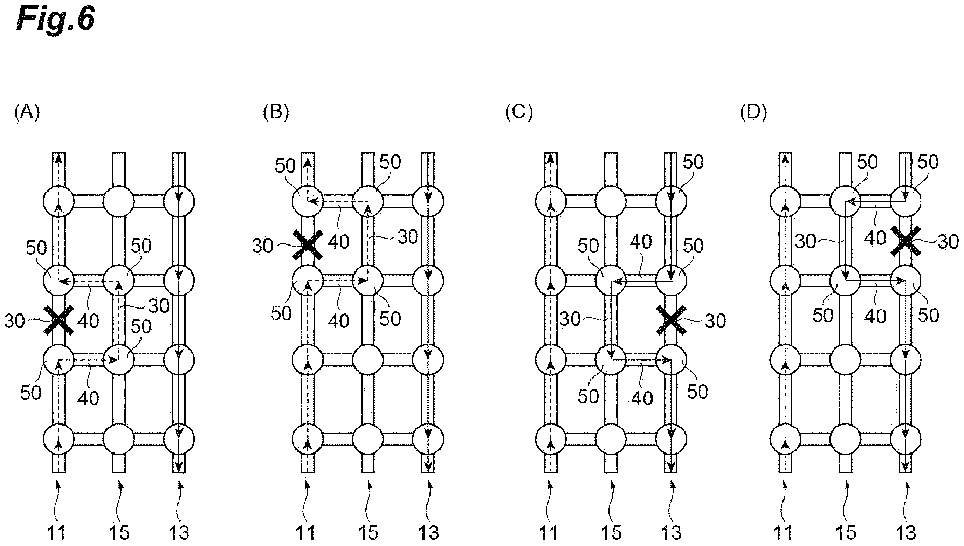

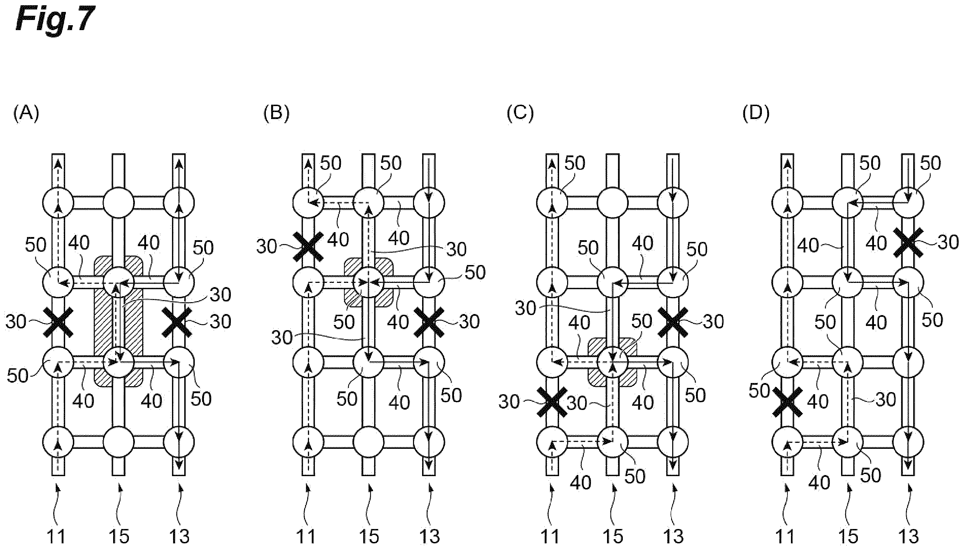

For example, when the fact that abnormality is present in a first conveyor unit 30 included in the first conveyor line 11 and the second conveyor line 13 has been detected by or input to the abnormal-state recognition unit 80, the control unit 90 starts up at least some of the first conveyor units 30 and the turn conveyor units 50 included in the backup line 15 that is stationary at the normal time from the stationary state, and also performs backup control of using the first connecting line 17, the second connecting line 19, and the backup line 15 and conveying an article F so as to detour around the first conveyor unit 30 having abnormality. The control unit 90 retrieves the shortest path for detouring around the first conveyor unit 30 having abnormality, and starts up, among the first conveyor units 30, the second conveyor units 40 and the turn conveyor units 50 included in the backup line 15, the first connecting lines 17, and the second connecting lines 19, only first conveyor units 30 and turn conveyor units 50 corresponding to the shortest path. The following describes the backup control of the control unit 90 in detail with reference to FIG. 6(A) to FIG. 6(D) and FIG. 7(A) to FIG. 7(D).

As illustrated in FIG. 6 (A) and FIG. 6 (B), when the fact that abnormality has occurred in one of the first conveyor units 30 included in the first conveyor line 11 (at the locations of × indicated in FIG. 6(A) and FIG. 6(B)) has been detected by (or input to) the abnormal-state recognition unit 80, the control unit 90 retrieves the shortest route along which the first conveyor unit 30 having abnormality can be detoured around. Specifically, the control unit 90 extracts conveyor units 3, 3 included in the first connecting lines 17 or the second connecting lines 19 that are located at both ends of the first conveyor unit 30 (a node portion described later) having abnormality, that is, extracts the turn conveyor units 50, 50 (link portions described later), and retrieves a detour route the starting point and the ending point of which are the turn conveyor units 50, 50.

The control unit 90 determines a detour route using the turn conveyor units 50, 50 disposed at both ends of the first conveyor unit 30 having abnormality and included in the first conveyor line 11 and the first connecting lines 17, second conveyor units 40, 40 connected to the respective turn conveyor units 50, 50 and included in the first connecting lines 17, turn conveyor units 50, 50 connected to these respective second conveyor units 40, 40 and included in the first connecting lines 17 and the backup line 15, and a first conveyor unit 30 interposed between these turn conveyor units 50, 50 and included in the backup line 15. The control unit 90 starts up, from the stationary state, the first conveyor unit 30 and the two turn conveyor units 50, 50 on the backup line 15 and the two second conveyor units 40, 40 that are in the stationary state and included in this detour route. The control unit 90 then causes an article F to be conveyed using the determined detour route so as to detour around the first conveyor unit 30 having abnormality.

As illustrated in FIG. 6(C) and FIG. 6(D), when the fact that abnormality has occurred in one of the first conveyor units 30 included in the second conveyor line 13 (at the locations of × indicated in FIG. 6(C) and FIG. 6(D)) has been detected by (or input to) the abnormal-state recognition unit 80, the control unit 90 retrieves the shortest route along which the first conveyor unit 30 having abnormality can be detoured around. Herein, the method of determining a detour route is the same as described above.

The control unit 90 determines a detour route using turn conveyor units 50, 50 disposed at both ends of the first conveyor unit 30 having abnormality and included in the second conveyor line 13 and the second connecting lines 19, second conveyor units 40, 40 connected to the respective turn conveyor units 50, 50 and included in the second connecting lines 19, turn conveyor units 50, 50 connected to these respective second conveyor units 40, 40 and included in the second connecting lines 19 and the backup line 15, and a first conveyor unit 30 interposed between these turn conveyor units 50, 50 and included in the backup line 15. The control unit 90 starts up, from the stationary state, the first conveyor unit 30 and the two turn conveyor units 50, 50 on the backup line 15 and the two second conveyor units 40, 40 that are in the stationary state and included in the detour route. The control unit 90 then causes an article F to be conveyed using the determined detour route so as to detour around the first conveyor unit 30 having abnormality.

The following describes a case with reference to FIG. 7(A) to FIG. 7(D) in which the fact that abnormality has occurred in both of a first conveyor unit 30 included in the first conveyor line 11 and a first conveyor unit 30 included in the second conveyor line 13 has been detected by (or input to) the abnormal-state recognition unit 80.

As illustrated in FIG. 7(A) to FIG. 7(D), the fact that abnormality has occurred in one of the first conveyor units 30 included in the first conveyor line 11 (at the locations of × indicated in FIG. 7(A) to FIG. 7(D)) has been detected by (or input to) the abnormal-state recognition unit 80, the control unit 90 retrieves the shortest route along which the first conveyor unit 30 having abnormality can be detoured around. Herein, the method of determining a detour route is the same as described above.

Specifically, the control unit 90 determines a detour route using turn conveyor units 50, 50 disposed at both ends of the first conveyor unit 30 having abnormality and included in the first conveyor line 11 and the first connecting lines 17, second conveyor units 40, 40 being adjacent to the respective turn conveyor units 50, 50 and included in the first connecting lines 17, turn conveyor units 50, 50 connected to these respective second conveyor units 40, 40 and included in the first connecting lines 17 and the backup line 15, and a first conveyor unit 30 interposed between these turn conveyor units 50, 50 and included in the backup line 15. The control unit 90 starts up, from the stationary state, the first conveyor unit 30 and the two turn conveyor units 50, 50 on the backup line 15 and the two second conveyor units 40, 40 that are in the stationary state and included in the detour route. The control unit 90 then causes an article F to be conveyed using the determined detour route so as to detour around the first conveyor unit 30 having abnormality.

In the same manner, when the fact that abnormality has occurred in one of the first conveyor units 30 included in the second conveyor line 13 has been detected by the abnormal-state recognition unit 80, the control unit 90 retrieves the shortest route along which the first conveyor unit 30 having abnormality can be detoured around. Herein, the method of determining a detour route is the same as described above.

Specifically, the control unit 90 determines a detour route using turn conveyor units 50, 50 disposed at both ends of the first conveyor unit 30 having abnormality and included in the second conveyor line 13 and the second connecting lines 19, second conveyor units 40, 40 connected to the respective turn conveyor units 50, 50 and included in the second connecting lines 19, turn conveyor units 50, 50 connected to these respective second conveyor units 40, 40 and included in the second connecting lines 19 and the backup line 15, and a first conveyor unit 30 interposed between these turn conveyor units 50, 50 and included in the backup line 15. The control unit 90 starts up, from the stationary state, the first conveyor unit 30, the two second conveyor units 40, 40 and the two turn conveyor units 50, 50 on the backup line 15 that are in the stationary state and included in this detour route. The control unit 90 then causes an article F to be conveyed using the determined detour route so as to detour around the first conveyor unit 30 having abnormality.

In the example illustrated in FIG. 7(A), part of the detour route for the first conveyor line 11 and part of the detour route for the second conveyor line 13 overlap each other in one first conveyor unit 30 and two turn conveyor units 50, 50 included in the backup line 15 (the hatched area indicated in FIG. 7(A)). Hereinafter, the connecting portion between the first conveyor line 11 and each first connecting line 17, the connecting portion between the backup line 15 and each first connecting line 17, the connecting portion between the second conveyor line 13 and each second connecting line 19, and the connecting portion between the backup line 15 and each second connecting line 19 will be described each as a link portion, and a portion interposed between link portions adjacent to each other will be described as a node portion.

If the detour routes for the first conveyor line 11 and the second conveyor line 13 overlap each other, there is a situation in which articles F collide with each other. In view of this, when an article F is located on a node portion, the control unit 90 inhibits rotation of turn conveyor units 50, 50 arranged in link portions at both ends of this node portion. More specifically, the control unit 90 inhibits rotation of the turn conveyor units 50, 50 other than rotation that allows entry to the turn conveyor units 50, 50 from the node portion interposed between the turn conveyor units 50, 50. This eliminates the possibility that two or more articles F are carried into the same node portion. Consequently, even when the backup control is performed by the control unit 90, articles F, F will not collide with each other.

In the examples illustrated in FIG. 7(B) and FIG. 7(C), part of the detour route for the first conveyor line 11 and part of the detour route for the second conveyor line 13 overlap each other in one turn conveyor unit 50 included in the backup line 15 (the hatched areas indicated in FIG. 7(B) and FIG. 7(C)). In this case also, when an article F is located on a node portion, the control unit 90 inhibits rotation of turn conveyor units 50, 50 arranged in link portions at both ends of this node portion. More specifically, the control unit 90 inhibits rotation of the turn conveyor units 50, 50 other than rotation that allows entry to the turn conveyor units 50, 50 from the node portion interposed between the turn conveyor units 50, 50.

In the example illustrated in FIG. 7(D), part of the detour route for the first conveyor line 11 and part of the detour route for the second conveyor line 13 do not overlap each other in a first conveyor unit 30 or a turn conveyor unit 50 included in the backup line 15. Thus, even when the backup control is performed by the control unit 90, articles F, F will not collide with each other. In other words, detour operation for the first conveyor line 11 and detour operation for the second conveyor line 13 can be processed inparallel. Even in this case, when an article F is located in a node portion, the control unit 90 may inhibit rotation of turn conveyor units 50, 50 arranged in link portions at both ends of this node portion.

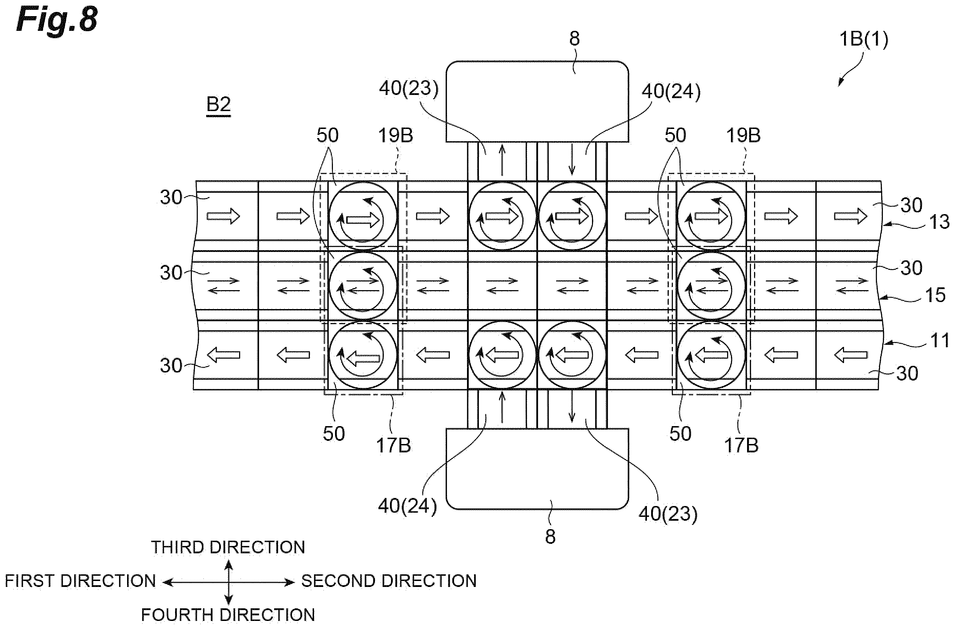

The following describes the conveyor system 1B disposed in the second building B2 in detail. Similarly to the conveyor system 1A, the conveyor system 1B also includes, as conveyor units 3 each configured to convey an article F while supporting a bottom portion thereof, first conveyor units 30 (see FIG. 3(A) and FIG. 3(B)), second conveyor units 40 (see FIG. 4(A) and FIG. 4(B)), and turn conveyor units 50 (see FIG. 5(A) and FIG. 5(B)). As illustrated in FIG. 8, the conveyor system 1B includes the first conveyor line 11, the second conveyor line 13, the backup line 15, a plurality of first connecting lines 17B, a plurality of second connecting lines 19B, an abnormal-state recognition unit 80 (see FIG. 1), and a control unit 90 (see FIG. 1).

The conveyor system 1B is different from the conveyor system 1A in the configuration of the first connecting lines 17B each configured to convey an article F between the first conveyor line 11 and the backup line 15, in the configuration of the second connecting lines 19B each configured to convey an article F between the second conveyor line 13 and the backup line 15, and in that the article carry-in-and-out line 21 disposed on the conveyor system 1A is omitted. Specifically, as illustrated in FIG. 8, between the first conveyor line 11 and the backup line 15 and between the second conveyor line 13 and the backup line 15, the second conveyor units 40 are not disposed. In other words, each first connecting line 17B is formed of only a turn conveyor unit 50 included in the first conveyor line 11 and a turn conveyor unit 50 included in the backup line 15, and an article F is passed directly between these turn conveyor units 50. In the same manner, each second connecting line 19B is formed of only a turn conveyor unit 50 included in the second conveyor line 13 and a turn conveyor unit 50 included in the backup line 15.

In the conveyor system 1B, each of the first conveyor line 11 and the second conveyor line 13 are disposed so as to face the corresponding inter-level conveying device 8 configured to convey an article in the vertical direction. Specifically, to turn conveyor units 50 included in the first conveyor line 11, second conveyor units 40, 40 forming respective loading-and-unloading conveyors (a loading conveyor 23 and an unloading conveyor 24) of an inter-level conveying device 8 are connected. Herein, the backup line 15 does not face the inter-level conveying device 8 (is not connected directly thereto). The configurations other than those described above are the same as those of the conveyor system 1A, and thus detailed description is omitted herein.

Backup control performed by the control unit 90 of the conveyor system 1B is the same as the backup control performed by the control unit 90 of the conveyor system 1A described above except that the second conveyor units 40 included in the first connecting line 17 and the second connecting line 19 are not involved. Thus, even if abnormality has occurred in a first conveyor unit 30 and a turn conveyor unit 50 in parts of the first conveyor line 11 and the second conveyor line 13 in conveyor system 1B, an article F can be conveyed while detouring around the first conveyor unit 30 and the turn conveyor unit 50 in which the abnormality has occurred.

The following describes the conveyor system 1C disposed in the inter-building structure C in detail. Similarly to the conveyor system 1A, the conveyor system 1C also includes, as conveyor units 3 each configured to convey an article F while supporting a bottom portion thereof, first conveyor units 30 (see FIG. 3(A) and FIG. 3(B)), second conveyor units 40 (see FIG. 4(A) and FIG. 4(B)), and turn conveyor units 50 (see FIG. 5(A) and FIG. 5(B)).

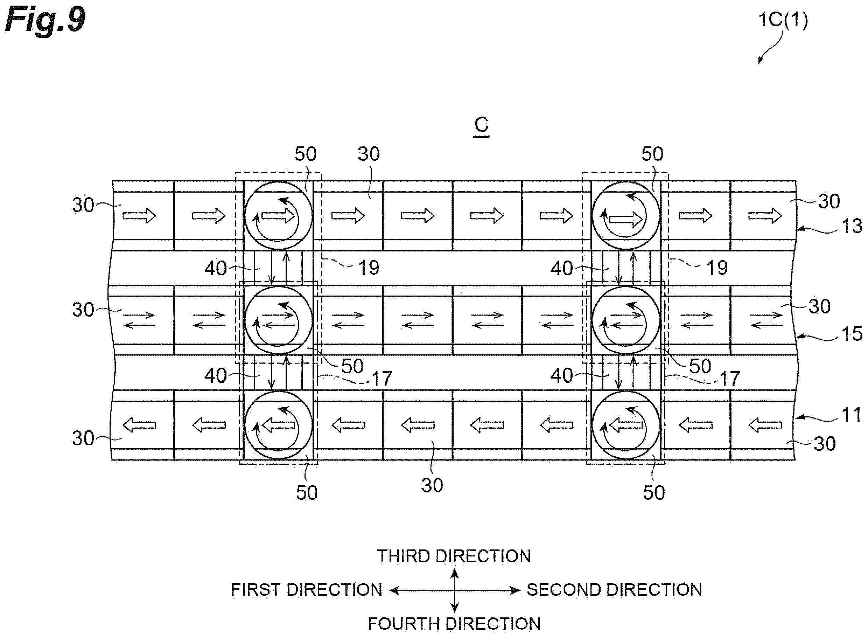

As illustrated in FIG. 9, the conveyor system 1C includes the first conveyor line 11, the second conveyor line 13, the backup line 15, a plurality of first connecting lines 17, a plurality of second connecting lines 19, an abnormal-state recognition unit 80 (see FIG. 1), and a control unit 90 (see FIG. 1). The conveyor system 1C is disposed between different buildings (the first building B1 and the second building B2) to connect the processing systems each disposed in the different buildings (the first building B1 and the second building B2) with each other.

The conveyor system 1C is different from the conveyor system 1A in that the intervals where the first connecting lines 17 and the second connecting lines 19 are arranged in the conveyance direction (the first direction and the second direction) are longer than those in the conveyor system 1A as illustrated in FIG. 8 and in that the article carry-in-and-out line 21 disposed on the conveyor system 1A is not provided. The configurations other than those described above are the same as those of the conveyor system 1A, and thus detailed description is omitted herein.

Backup control performed by the control unit 90 of the conveyor system 1C also is the same as the backup control performed by the control unit 90 of the conveyor system 1A described above. Thus, even if abnormality has occurred in a first conveyor unit 30 and a turn conveyor unit 50 in parts of the first conveyor line 11 and the second conveyor line 13 in the conveyor system 1C, an article F can be conveyed while detouring around the first conveyor unit 30 and the turn conveyor unit 50 in which the abnormality has occurred.

The following describes functional effects of the conveyor system 1 according to the embodiment described above. In the conveyor system 1 according to the embodiment, instead of providing backup lines corresponding to the respective ones of the first conveyor line 11 and the second conveyor line 13, only one backup line 15 shared by the first conveyor line 11 and the second conveyor line 13 is provided. The first connecting lines 17 are configured to carry in and carry out the article between the one backup line 15 and the first conveyor line 11. The second connecting lines 19 are configured to carry in and carry out the article between the one backup line 15 and the second conveyor line 13. By this configuration, the same function as in the configuration in which backup lines are provided with the respective ones of the first conveyor line 11 and the second conveyor line 13 can be implemented by the one backup line 15. Consequently, the backup line 15 configured to substitutively convey an article F when abnormality has occurred in the first conveyor line 11 and the second conveyor line 13 can be built compact.

In the conveyor system 1 according to the embodiment, first conveyor units 30 and turn conveyor units 50 that are in the stationary state at the normal time and included in the backup line 15 automatically start up at abnormal time. Specifically, at abnormal time, the backup line 15, the first connecting lines 17, and the second connecting lines 19 automatically start up. This enables article conveyance using the backup line 15, the first connecting lines 17, and the second connecting lines 19 while detouring around abnormal locations. Consequently, even if abnormality has occurred in at least one of the first conveyor line 11 and the second conveyor line 13, conveyance of an article F can be continued without stopping the conveyance.

In the conveyor system 1 according to the embodiment, conveyor units 3 disposed in link portions are turn conveyor units 50 each configured to convey an article F while supporting a bottom portion thereof and also rotate the article F about the vertical direction as a rotation axis. By this configuration, when an article F such as a FOUP the front-back orientation of which is specified is conveyed, the article F can be conveyed with the orientation being kept.

In the conveyor system 1 according to the embodiment, when an article F is located in a node portion, each control unit 90 inhibits rotation of turn conveyor units 50 arranged in link portions at both ends of this node portion. By this control, articles F, F can be prevented from colliding with each other during the backup control performed by the control unit 90.

In the conveyor system 1 according to the embodiment, the control unit 90 retrieves the shortest path for detouring around a first conveyor unit 30 having abnormality in the first conveyor line 11 and the second conveyor line 13, and starts up, among conveyor units 3 (first conveyor units 30 and turn conveyor units 50) included in the backup line 15, only first conveyor units 30 and turn conveyor units 50 corresponding to the shortest path. By this control, the number of first conveyor units 30 and turn conveyor units 50 to be started up as the backup line 15 can be minimized. Furthermore, in the embodiment, the distance in the conveyance direction of the backup line 15 to be used for detouring one abnormal location can be reduced. Thus, even if abnormality has occurred in a plurality of locations, the possibility of being able to detour around them at the same time can be increased. Consequently, reduction in operating rate when abnormality has occurred in at least one of the first conveyor line 11 and the second conveyor line 13 can be prevented or reduced.

In the conveyor system 1 according to the embodiment, the backup line 15 is disposed between the first conveyor line 11 and the second conveyor line 13 in the width direction, and thus the first connecting lines 17 and the second connecting lines 19 can be built simply.

In the conveyor system 1 according to the embodiment, each first connecting line 17 and each second connecting line 19 are provided so as to be able to convey an article F in both directions of the third direction and the fourth direction. Thus, for the control unit 90 to perform the backup control, more detour routes can be selected. Consequently, for example, abnormal locations can be detoured around along a shorter route.

In the conveyor system 1 according to the embodiment, the backup line 15 can be built compact. Thus, even in a place where the inter-level conveying device 8 is arranged and space for installation is limited, the backup line 15 can be built.

In the conveyor system 1 according to the embodiment, only one backup line needs to be installed. Thus, even when the conveyor system is installed over a relatively long distance between buildings, increase of the cost can be suppressed.

Although one embodiment according to one aspect of the present invention has been described above, the aspect of the present invention is not limited to the embodiment, and various modifications may be made within the scope of the claims not departing from the gist of the invention.

### <Modification 1>

An example has been described in which the turn conveyor units 40 used in the first connecting lines 17 and the second connecting lines 19 according to the embodiment are provided so as to be able to convey an article F in both directions of the third direction and the fourth direction. However, the present invention is not limited to this.

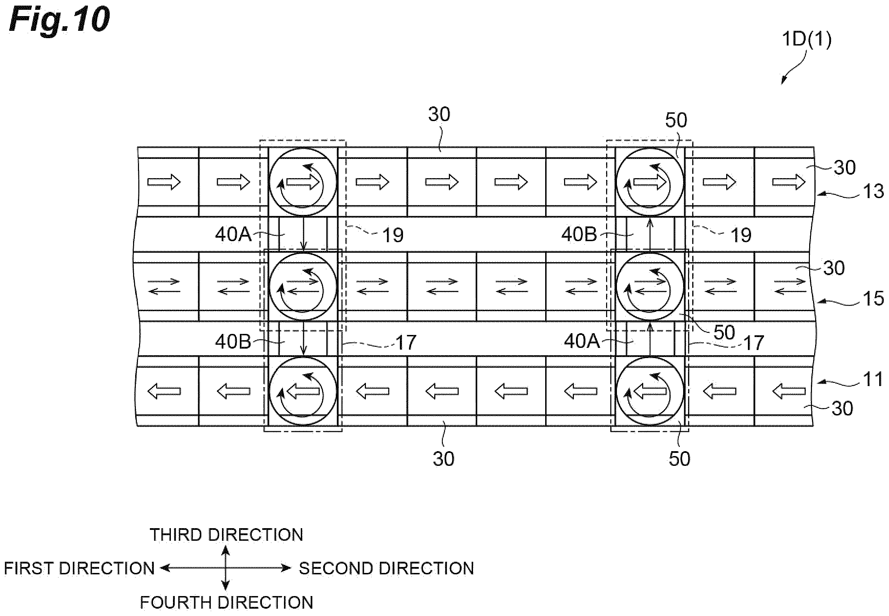

For example, as illustrated in FIG. 10, the conveyor system 1 may be configured as a conveyor system 1D in which the first connecting lines 17 include one or more second conveyor units 40A each configured to be able to convey an article F only in a carry-indirection (third direction) in which the article F is carried in on the backup line 15, and also include one or more second conveyor units 40B each configured to be able to convey an article F only in a carry-out direction (fourth direction) in which the article F is carried out from the backup line 15.

Furthermore, for example, the conveyor system 1 may be configured as the conveyor system 1D in which the second connecting lines 19 include one or more second conveyor units 40A each configured to be able to convey an article F only in a carry-in direction (fourth direction) in which the article F is carried in on the backup line 15, and also include one or more second conveyor units 40B each configured to be able to convey an article F only in a carry-out direction (third direction) in which the article F is carried out from the backup line 15.

In the configuration according to this modification 1 also, for example, even if abnormality has occurred in a first conveyor unit 30 between a second conveyor unit 40A and a second conveyor unit 40B in the first conveyor line 11 (or the second conveyor line 13), the control unit 90 can perform backup control of detouring around the first conveyor unit 30 having the abnormality. To perform this backup control, simple control can be used.

### <Modification 2>

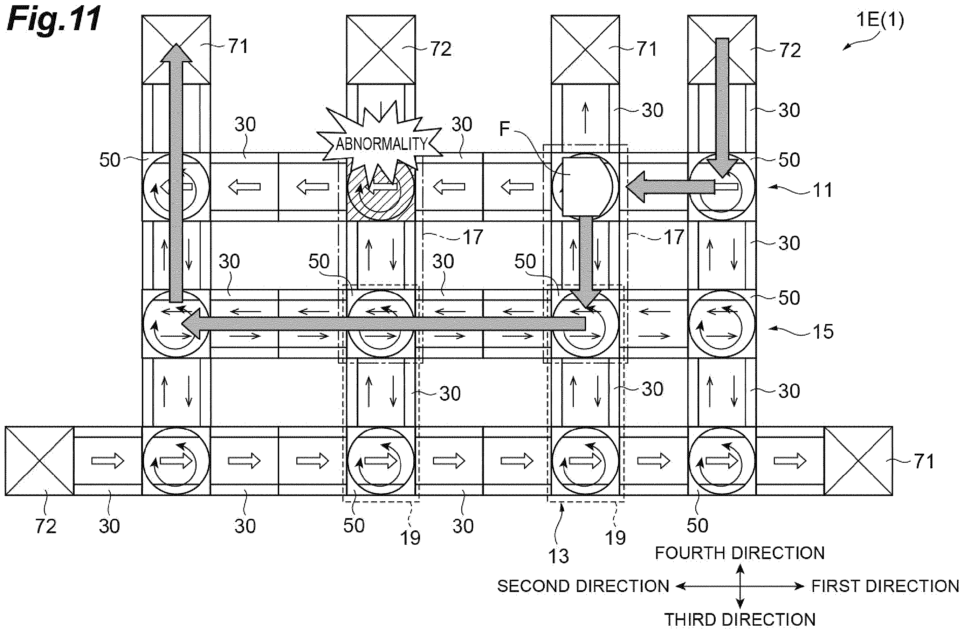

An example has been described in which the conveyor system 1 (1A to 1D) according to the embodiment is built so as to be relatively long in the conveyance direction. However, as illustrated in FIG. 11, the conveyor system 1 may be configured as a conveyor system 1E in which the first conveyor line 11, the second conveyor line 13, the backup line 15, the first connecting lines 17, and the second connecting lines 19 are disposed in a gridpattern. Therein, carry-in ports 71 each configured to carry an article F into the conveyor system 1E and carry-out ports 72 each configured to carry an article F out from the conveyor system 1E face the first conveyor line 11 and the second conveyor line 13.

In the embodiment, an example has been described in which abnormality has occurred in a first conveyor unit 30 included in the first conveyor line 11 and/or the second conveyor line 13. However, the present invention is not limited to this. For example, as illustrated in FIG. 11, if abnormality has occurred in a turn conveyor unit 50 (link portion) included in the first conveyor line 11 and/or the second conveyor line 13, an article F may be carried in on the backup line 15 or carried out from the backup line 15 by using two turn conveyor units 50, 50 (link portions) adjacent to the turn conveyor unit 50 in the first direction or the second direction (conveyance direction). Even in this case, the control unit 90 retrieves a detour route the starting point and the ending point of which are these turn conveyor units 50, 50, and can determine the shortest route along which the turn conveyor unit 50 having the abnormality can be detoured around.

### <Other Modifications>

In the embodiment or the modifications described above, an example has been described in which, in order to convey an article F in the first direction or the second direction, a plurality of first conveyor units 30 are arranged. Alternatively, in a part corresponding to each node portion, one conveyor unit 3 extending in the conveyance direction may be disposed.

In the embodiment or the modifications, an example has been described in which the control unit 90 and the abnormal-state recognition unit 80 are provided in each of the conveyor systems 1A to 1C. Alternatively, one control unit and one abnormal-state recognition unit that control the conveyor systems 1A to 1C in a centralized manner may be provided, or the control unit and the abnormal-state recognition unit may be provided in each conveyor unit.

In the embodiment or the modifications, an example has been described in which the backup line 15 is disposed between the first conveyor line 11 and the second conveyor line 13. Alternatively, the backup line 15 may be disposed outside the first conveyor line 11, or may be disposed outside the second conveyor line 13, for example.

In the embodiment or the modifications, an example has been described in which each first connecting line 17 and the corresponding second connecting line 19 are disposed linearly in the width direction orthogonal to the conveyance direction as illustrated in FIG. 2 and FIG. 8 to FIG. 11. Alternatively, the first connecting line 17 and the second connecting line 19 may be disposed in a manner displaced in the extending direction thereof (in a manner nonlinear in the width direction).

In the embodiment or the modifications, an example has been described in which the first connecting lines 17 and the second connecting lines 19 are formed by providing a turn conveyor unit 50 in a location corresponding to each link portion. However, the present invention is not limited to this. For example, the first connecting lines 17 and the second connecting lines 19 may be formed by providing pushers each configured to push an article F in the third direction or the fourth direction. In other words, by the pusher, an article F may be carried in on the backup line 15 from the first conveyor line 11 or the second conveyor line 13, or an article F may be carried out therefrom to the first conveyor line 11 or the second conveyor line 13. In this case, the second conveyor units 40 forming part of each first connecting line 17 and part of each second connecting line 19 and illustrated in FIG. 2 may be configured as roller conveyors having no drive section 46.

### Reference Signs List

1 (1A, 1B, 1C, 1D, 1E) ... conveyor system, 3 ... conveyor unit (conveyor device), 6 ... stocker, 7 ... processing device, 8 ... inter-level conveying device, 11 ... first conveyor line, 13 ... second conveyor line, 15 ... backup line, 17, 17B ... first connecting line, 19, 19B ... second connecting line, 23 ... loading conveyor, 24 ... unloading conveyor, 30 ... first conveyor unit, 40, 40A, 40B ... second conveyor unit, 50 ... turn conveyor unit (turning conveyor device), 80 ... abnormal-state recognition unit, 90 ... control unit, B1 ... first building, B2 ... second building, C ... inter-building structure, F ... article

## Claims

1. A conveyor system including conveyor devices configured to convey an article while supporting a bottom portion of the article, the conveyor system comprising:
a first conveyor line configured to convey the article in a first direction;
a second conveyor line arranged in parallel with the first conveyor line and configured to convey the article in a second direction that is a direction opposite to the first direction;
a backup line arranged in parallel with the first conveyor line and the second conveyor line and provided so as to be able to change states between a state of conveying the article in the first direction and a state of conveying the article in the second direction;
first connecting lines each configured to convey the article between the first conveyor line and the backup line; and
second connecting lines each configured to convey the article between the second conveyor line and the backup line.

2. The conveyor system according to claim 1 further comprising:
a control unit configured to control the conveyor devices included in each of the first conveyor line, the second conveyor line, the backup line, the first connecting lines, and the second connecting lines; and
an abnormal-state recognition unit configured to recognize that abnormality is present in at least one of the conveyor devices included in each of the first conveyor line and the second conveyor line, wherein
the control unit starts up at least some of the conveyor devices included in the backup line from a stationary state, and performs backup control using the first connecting lines, the second connecting lines, and the backup line to convey the article so as to detour around the at least one of the conveyor devices having the abnormality, when the abnormal-state recognition unit has recognized that abnormality is present.

3. The conveyor system according to claim 2, wherein, as the conveyor device, turning conveyor devices each configured to convey the article while supporting a bottom portion of the article and to rotate the article about the vertical direction as a rotation axis are disposed at connecting portions between the first conveyor line and the first connecting lines, connecting portions between the backup line and the first connecting lines, connecting portions between the second conveyor line and the second connecting lines, and connecting portions between the backup line and the second connecting lines.

4. The conveyor system according to claim 3, wherein, the control unit inhibits rotation of the turning conveyor devices disposed at two of the connecting portions respectively, when the article is located on one of the conveyor devices disposed between two of the connecting portions adjacent to each other.

5. The conveyor system according to any one of claims 2 to 4, wherein the control unit searches for a shortest path for detouring around the at least one of the conveyor devices having abnormality, and starts up only conveyor devices corresponding to the shortest path among the conveyor devices included in the backup line.

6. The conveyor system according to any one of claims 1 to 5, wherein the backup line is arranged between the first conveyor line and the second conveyor line in a width direction orthogonal to the first direction.

7. The conveyor system according to any one of claims 1 to 6, wherein the first connecting lines and the second connecting lines are provided so as to be able to convey the article in both directions of a carry-in direction in which the article is carried into the backup line and a carry-out direction in which the article is carried out from the backup line.

8. The conveyor system according to any one of claims 1 to 7, wherein the first conveyor line and the second conveyor line are disposed so as to face an inter-level conveying device configured to convey an article in the vertical direction, and also are connected to a loading-and-unloading conveyor of the inter-level conveying device.

9. The conveyor system according to any one of claims 1 to 8 that is disposed between different buildings to connect processing systems disposed in the respective different buildings with each other.
